# FASCICULE DE BREVET EUROPEEN

(11) **EP 2 122 392 B1**
(45) Date de publication et mention de la délivrance du brevet: **18.12.2019**
(21) Numéro de dépôt: 08709189.8
(22) Date de dépôt: 22.02.2008
(51) Int. Cl.: G02B 1/10, G02C 7/02, G02C 7/10

(54) **PROCEDE DE FABRICATION D'UN ARTICLE D'OPTIQUE REVETU D'UN REVETEMENT ANTI-REFLETS OU REFLECHISSANT AYANT DES PROPRIETES D'ADHESION ET DE RESISTANCE A L'ABRASION AMELIOREES**
PROZESS ZUR HERSTELLUNG EINES MIT EINER ANTIREFLEX- ODER REFLEKTIERENDEN BESCHICHTUNG BESCHICHTETEN OPTISCHEN ARTIKELS MIT VERBESSERTEN ADHÄSIONS- UND ABRASIONSBESTÄNDIGKEITSEIGENSCHAFTEN
PROCESS FOR MANUFACTURING AN OPTICAL ARTICLE COATED WITH AN ANTIREFLECTION OR REFLECTIVE COATING HAVING IMPROVED ADHESION AND ABRASION-RESISTANCE PROPERTIES

(30) Priorité: 23.02.2007 FR 0753483
(43) Date de publication de la demande: 25.11.2009
(73) Titulaire: Essilor International, 94220 Charenton-le-Pont (FR)
(72) Inventeur: ROISIN, Philippe, F-94220 Charenton-Le-Pont (FR); THOMAS, Michèle, F-94220 Charenton-Le-Pont (FR)
(74) Mandataire: Jacobacci Coralis Harle
(86) Numéro de dépôt international: PCT/EP2008/052212
(87) Numéro de publication internationale: WO 2008/107325

(56) Documents cités:
- EP-A- 1 306 695
- EP-A1- 0 699 926
- EP-A2- 1 013 793
- WO-A-02/44440
- FR-A1- 2 713 668
- FR-A1- 2 847 346
- FR-A1- 2 859 485
- US-A- 5 993 614

## Description

La présente invention concerne un procédé de préparation d'un article d'optique comprenant un substrat revêtu d'un revêtement anti-reflets ou d'un revêtement réfléchissant comprenant une sous-couche, possédant notamment une résistance à l'abrasion accrue et de bonnes propriétés d'adhésion au substrat.

Dans le domaine de l'optique ophtalmique, il est classique de revêtir une lentille ophtalmique de divers revêtements afin de conférer à cette lentille diverses propriétés mécaniques et/ou optiques. Ainsi, classiquement, on forme sur une lentille ophtalmique successivement des revêtements tels que des revêtements anti-chocs, anti-abrasion, anti-reflets et/ou réfléchissants.

Un revêtement anti-reflets se définit comme un revêtement, déposé à la surface d'un article d'optique, qui améliore les propriétés anti-réfléchissantes de l'article d'optique final. Il permet de réduire la réflexion de la lumière à l'interface article-air sur une portion relativement large du spectre visible.

Un revêtement réfléchissant réalise l'effet inverse, c'est-à-dire qu'il augmente la réflexion des rayons lumineux. Un tel type de revêtement est utilisé par exemple, pour obtenir un effet miroir dans des lentilles solaires.

Les revêtements anti-reflets sont bien connus et comprennent classiquement un empilement monocouche ou multicouches de matériaux diélectriques tels que SiO, SiO₂, Al₂O₃, MgF₂, LiF, Si₃N₄, TiO₂, ZrO₂, Nb₂O₅, Y₂O₃, HfO₂, Sc₂O₃, Ta₂O₅, Pr₂O₃, ou leurs mélanges.

Comme cela est bien connu également, les revêtements anti-reflets sont, de préférence, des revêtements multicouches comprenant alternativement des couches de haut indice de réfraction et des couches de bas indice de réfraction.

Les revêtements réfléchissants sont constitués de couches de même nature que les revêtements anti-reflets, mais les indices de réfraction nombres et épaisseurs des couches sont choisis de façon à ce que le revêtement soit réfléchissant, ce qui est bien connu de l'homme de l'art.

La suite de la description se réfère à des revêtements anti-reflets mais s'applique aussi à des revêtements réfléchissants. L'invention s'applique toutefois de façon préférentielle à des revêtements anti-reflets.

Il est connu d'interposer une sous-couche d'épaisseur relativement importante entre le substrat et les couches de haut indice de réfraction et de bas indice de réfraction du revêtement anti-reflets dans le but d'améliorer la résistance à l'abrasion et/ou aux rayures dudit revêtement.

Cependant, il a été constaté que l'introduction de cette sous-couche, tout en augmentant les propriétés de résistance à l'abrasion, pouvait fragiliser l'empilement anti-reflets et nuire à son adhésion au substrat. Des défaillances sont notamment observées au niveau de l'interface sous-couche/empilement optique anti-reflets.

La demande de brevet WO 2005/059603, au nom du déposant, décrit un article comprenant un revêtement anti-reflets multicouches coloré comprenant au moins deux couches de haut indice de réfraction absorbant dans le visible à base d'oxyde de titane sous-stoechiométrique TiOₓ (x < 2) et de préférence au moins une couche de bas indice de réfraction (BI) à base de SiO₂ dopée par 1-5 % en masse d'Al₂O₃, par rapport à la masse totale SiO₂ + Al₂O₃.

Ce document décrit plus particulièrement un substrat revêtu successivement d'une sous-couche de silice de 100-110 nm d'épaisseur, d'une couche de TiOₓ, d'une couche de SiO₂/Al₂O₃, d'une couche de TiOₓ, d'une couche de SiO₂/Al₂O₃, d'une couche de TiOₓ, d'une couche de SiO₂/Al₂O₃ et d'un revêtement anti-salissures.

Avant le dépôt du revêtement anti-reflets, la surface du substrat est soumise à un traitement destiné à augmenter l'adhésion de la sous-couche. Cette préparation de surface, nommée IPC (Ion Pre-cleaning), consiste en un pré-nettoyage ionique par bombardement du substrat par des ions argon à l'aide d'un canon à ions.

Aucun traitement de surface de la sous-couche n'est effectué.

L'article d'optique obtenu selon l'enseignement de la demande de brevet WO 2005/059603 possède des propriétés d'adhésion et de résistance à l'abrasion satisfaisantes, mais qui peuvent toutefois être améliorées.

Le document US-A-5993614 divulgue un procédé de réalisation d'un revêtement anti reflets comprenant le dépôt d'une sous couche. La présente invention a donc pour objectif de fournir un procédé de préparation d'un article d'optique transparent, notamment une lentille ophtalmique, comprenant un substrat en verre minéral ou organique et un revêtement anti-reflets incluant une sous-couche, lequel a l'avantage de posséder à la fois des propriétés de résistance à l'abrasion et d'adhésion améliorées par rapport aux articles d'optique de l'art antérieur.

Ce nouveau procédé doit pouvoir s'intégrer aisément dans le processus classique de fabrication des articles d'optique, et de préférence éviter un chauffage du substrat.

Les articles d'optique préparés doivent conserver d'excellentes propriétés de transparence, présenter une bonne résistance à un traitement au trempé dans l'eau chaude suivi d'une sollicitation mécanique de surface, et être exempts de défauts optiques.

Un autre objectif de l'invention est de fournir un procédé de préparation de tels articles d'optique, dotés en outre de propriétés antistatiques.

La présente invention a notamment été conçue pour résoudre le problème de l'adhésion au substrat de l'empilement anti-reflets, tout en veillant à ce que la résolution de ce problème soit accompagnée de l'amélioration de la résistance à l'abrasion dudit revêtement.

Les buts fixés ci-dessus sont atteints selon l'invention par un procédé de fabrication d'un article d'optique à propriétés anti-reflets ou réfléchissantes comprenant un substrat, ledit procédé comprenant au moins les étapes suivantes :
- fournir un article d'optique comprenant un substrat ayant au moins une surface principale;
- déposer sur une surface principale du substrat une sous-couche ayant une surface exposée;
- déposer sur ladite surface exposée de la sous-couche un empilement anti-reflets multicouches comprenant au moins une couche de haut indice de réfraction et au moins une couche de bas indice de réfraction,
- récupérer un article d'optique comprenant un substrat ayant une surface principale revêtue d'un revêtement anti-reflets comprenant ladite sous-couche et ledit empilement multicouches,
la surface exposée de ladite sous-couche étant soumise à un traitement de bombardement ionique avant le dépôt dudit empilement multicouches.

Dans la présente demande, lorsqu'un article d'optique comprend un ou plusieurs revêtements à sa surface, l'expression "déposer une couche ou un revêtement sur l'article" signifie qu'une couche ou un revêtement est déposé sur la surface à découvert (exposée) du revêtement externe de l'article.

Par revêtement externe d'un article, on entend le revêtement qui est le plus éloigné du substrat.

Un revêtement qui est "sur" un substrat ou qui a été déposé "sur" un substrat est défini comme un revêtement qui (i) est positionné au-dessus du substrat, (ii) n'est pas nécessairement en contact avec le substrat, c'est-à-dire qu'un ou plusieurs revêtements intermédiaires peuvent être disposés entre le substrat et le revêtement en question, et (iii) ne recouvre pas nécessairement le substrat complètement, le recouvrement complet étant toutefois préférentiel.

Lorsque "une couche 1 est localisée sous une couche 2", on comprendra que la couche 2 est plus éloignée du substrat que la couche 1.

Par "empilement anti-reflets multicouches," on entend l'empilement multicouches du revêtement anti-reflets qui est déposé sur la sous-couche du revêtement anti-reflets. Dans le reste de la demande, il sera simplement appelé "empilement multicouches."

L'article d'optique préparé selon l'invention comprend un substrat, de préférence transparent, en verre organique ou minéral, ayant des faces principales avant et arrière, l'une au moins desdites faces principales comportant un revêtement anti-reflets comprenant une sous-couche revêtue d'un empilement multicouches, de préférence les deux faces principales. De préférence encore, l'empilement multicouches est directement en contact avec la sous-couche.

De manière générale, la sous-couche et l'empilement multicouches du revêtement anti-reflets de l'article d'optique selon l'invention peuvent être déposés sur tout substrat, et de préférence sur des substrats en verre organique, par exemple une matière plastique thermoplastique ou thermodurcissable.

Parmi les matériaux thermoplastiques convenant pour les substrats, on peut citer les (co)polymères (méth)acryliques, en particulier le poly(méthacrylate de méthyle) (PMMA), les (co)polymères thio(méth)acryliques, le polyvinylbutyral (PVB), les polycarbonates (PC), les polyuréthanes (PU), les poly(thiouréthanes), les (co)polymères d'allylcarbonates de polyols, les copolymères thermoplastiques éthylène/acétate de vinyle, les polyesters tels que le poly(téréphtalate d'éthylène) (PET) ou le poly(téréphtalate de butylène) (PBT), les polyépisulfures, les polyépoxydes, les copolymères polycarbonates/polyesters, les copolymères de cyclooléfines tels que les copolymères éthylène/norbornène ou éthylène/cyclopentadiène et leurs combinaisons.

Par (co)polymère, on entend un copolymère ou un polymère. Par (méth)acrylate, on entend un acrylate ou un méthacrylate.

Parmi les substrats préférés selon l'invention, on peut citer des substrats obtenus par polymérisation des (métha)crylates d'alkyle, en particulier des (méth)acrylates d'alkyle en C₁-C₄, tels que le (méth)acrylate de méthyle et le (méth)acrylate d'éthyle, des (méth)acrylates aromatiques polyéthoxylés tels que les di(méth)acrylates de bisphénols polyéthoxylés, des dérivés allyles tels que les allylcarbonates de polyols aliphatiques ou aromatiques, linéaires ou ramifiés, des thio(méth)acrylates, des épisulfures et de mélanges précurseurs polythiols/polyisocyanates (pour l'obtention de polythiouréthanes).

Par polycarbonate (PC), on entend au sens de la présente invention aussi bien les homopolycarbonates que les copolycarbonates et les copolycarbonates séquencés. Les polycarbonates sont disponibles dans le commerce, par exemple auprès des sociétés GENERAL ELECTRIC COMPANY sous la marque LEXAN®, TEIJIN sous la marque PANLITE®, BAYER sous la marque BAYBLEND®, MOBAY CHEMICHAL Corp. sous la marque MAKROLON® et DOW CHEMICAL Co. sous la marque CALIBRE®.

Comme exemples de (co)polymères d'allyl carbonates de polyols, on peut citer les (co)polymères d'éthylèneglycol bis (allyl carbonate), de diéthylèneglycol bis 2-méthyl carbonate, de diéthylèneglycol bis (allyl carbonate), d'éthylèneglycol bis (2-chloro allyl carbonate), de triéthylèneglycol bis (allyl carbonate), de 1,3-propanediol bis (allyl carbonate), de propylèneglycol bis (2-éthyl allyl carbonate), de 1,3-butènediol bis (allyl carbonate), de 1,4-butènediol bis (2-bromo allyl carbonate), de dipropylèneglycol bis (allyl carbonate), de triméthylèneglycol bis (2-éthyl allyl carbonate), de pentaméthylèneglycol bis (allyl carbonate), d'isopropylène bisphénol A bis (allyl carbonate).

Les substrats particulièrement recommandés sont les substrats obtenus par (co)polymérisation du bis allyl carbonate du diéthylèneglycol, vendu, par exemple, sous la dénomination commerciale CR-39® par la société PPG Industries (lentilles ORMA® ESSILOR).

Parmi les substrats également particulièrement recommandés, on peut citer les substrats obtenus par polymérisation des monomères thio(méth)acryliques, tels que ceux décrits dans la demande de brevet français FR 2734827.

Bien évidemment, les substrats peuvent être obtenus par polymérisation de mélanges des monomères ci-dessus, ou peuvent encore comprendre des mélanges de ces polymères et (co)polymères.

D'une manière générale, les substrats préférés sont les substrats en matériau réticulé (thermodurcissables), en particulier les substrats allyliques, (méth)acrylates, thio(méth)acrylates, ou poly(thio)uréthane.

Les substrats organiques préférés dans le cadre de l'invention sont ceux présentant un coefficient de dilatation thermique de 50.10⁻⁶ °C⁻¹ à 180.10⁻⁶ °C⁻¹, et préférentiellement de 100.10⁻⁶ °C⁻¹ à 180.10⁻⁶ °C⁻¹.

Selon un mode de réalisation de l'invention, le substrat comprend une face avant et une face arrière, le revêtement anti-reflets pouvant être appliqué sur au moins l'une des deux. Il est de préférence appliqué sur les faces avant et arrière du substrat.

Par face arrière (généralement concave) du substrat, on entend la face qui, lors de l'utilisation de l'article, est la plus proche de l'œil du porteur. Inversement, par face avant (généralement convexe) du substrat, on entend la face qui, lors de l'utilisation de l'article, est la plus éloignée de l'œil du porteur.

Avant le dépôt de la sous-couche sur le substrat éventuellement revêtu, par exemple d'une couche anti-abrasion et/ou anti-rayures, il est courant de soumettre la surface dudit substrat éventuellement revêtue à un traitement destiné à augmenter l'adhésion de la sous-couche, qui est généralement conduit sous vide, tel qu'un bombardement avec des espèces énergétiques, par exemple un faisceau d'ions ("Ion Pre-Cleaning" ou "IPC"), un traitement par décharge corona, par effluvage ou un traitement par plasma sous vide. Grâce à ces traitements de nettoyage, la propreté de la surface du substrat est optimisée. Un traitement par bombardement ionique est préféré, qui utilise de préférence en tant que gaz ionisé l'argon, l'oxygène, ou leurs mélanges, sous une tension d'accélération allant généralement de 50 à 200 V et une intensité allant généralement de 1 A à 4 A.

Par espèces énergétiques, on entend des espèces ayant une énergie allant de 1 à 150 eV, de préférence de 10 à 150 eV, et mieux de 40 à 150 eV. Les espèces énergétiques peuvent être des espèces chimiques telles que des ions, des radicaux, ou des espèces telles que des photons ou des électrons.

Par bombardement ionique, on entend un bombardement par des ions ayant une énergie supérieure ou égale à 30 eV, de préférence supérieure ou égale à 40 eV.

Selon la présente invention, une sous-couche est utilisée en combinaison avec un empilement multicouches comprenant au moins une couche de haut indice de réfraction et au moins une couche de bas indice de réfraction.

Par sous-couche, ou couche d'adhésion, on entend un revêtement qui est déposé sur le substrat (nu ou revêtu) avant le dépôt de l'empilement multicouches de l'invention. La sous-couche doit avoir une épaisseur suffisante pour promouvoir la résistance à l'abrasion du revêtement anti-reflets, mais de préférence pas trop importante pour ne pas provoquer une absorption lumineuse qui réduirait significativement le facteur relatif de transmission τv.

Compte tenu de son épaisseur relativement importante, la sous-couche ne participe généralement pas à l'activité optique anti-réfléchissante, en particulier dans le cas où elle possède un indice de réfraction équivalent à celui du substrat ou du substrat revêtu.

La sous-couche comprend de préférence une couche à base de SiO₂, d'épaisseur de préférence supérieure ou égale à 75 nm, de préférence encore supérieure ou égale à 80 nm, mieux supérieure ou égale à 100 nm et encore mieux supérieure ou égale à 150 nm. Son épaisseur est généralement inférieure à 250 nm, mieux inférieure à 200 nm. Selon un mode de réalisation particulier, la sous-couche consiste en la couche à base de SiO₂ précitée.

De préférence, la couche à base de SiO₂ de la sous-couche, qui peut être une couche de SiO₂, est directement en contact avec l'empilement multicouches.

Ladite couche à base de SiO₂ peut comprendre, en plus de la silice, un ou plusieurs autres matériaux conventionnellement utilisés pour la fabrication de sous-couches, par exemple un ou plusieurs matériaux choisis parmi les matériaux diélectriques décrits précédemment dans la présente description. Cette couche à base de SiO₂ est de préférence exempte d'Al₂O₃, mieux consiste en une couche de SiO₂.

La sous-couche de la présente invention comprend de préférence au moins 70 % en masse de SiO₂, mieux au moins 80 % en masse et mieux encore au moins 90 % en masse de SiO₂. Comme il a été dit, dans une réalisation optimale, ladite sous-couche comprend 100 % en masse de silice.

Il est préférable d'utiliser une sous-couche de type monocouche. Toutefois, la sous-couche peut être laminée (multicouches). Dans ce cas, elle comprend au moins une couche à base de SiO₂ d'épaisseur de préférence supérieure ou égale à 75 nm et de préférence exempte d'Al₂O₃ et venant préférentiellement en contact direct avec l'empilement multicouches.

La sous-couche multicouches comprend préférentiellement une couche de SiO₂ exempte d'Al₂O₃ d'épaisseur de préférence supérieure ou égale 75 nm, de préférence encore supérieure ou égale à 80 nm, mieux supérieure ou égale à 100 nm et encore mieux supérieure ou égale à 150 nm et au plus trois couches, de préférence au plus deux couches, intercalées entre le substrat, éventuellement revêtu, et cette couche de SiO₂ exempte d'Al₂O₃.

En particulier, lorsque le substrat possède un indice de réfraction élevé (terme par lequel on entend un indice de réfraction supérieur ou égal à 1,55, de préférence supérieur ou égal à 1,57) et que la sous-couche est déposée directement sur le substrat ou que le substrat est revêtu d'un revêtement anti-abrasion et/ou anti-rayures d'indice de réfraction élevé (c'est-à-dire supérieur ou égal à 1,55, de préférence supérieur ou égal à 1,57), préférentiellement à base d'époxysilanes, et que la sous-couche est déposée directement sur ce revêtement anti-abrasion et/ou anti-rayures, la sous-couche comprend préférentiellement, outre la couche de SiO₂ précitée, une couche d'indice de réfraction élevé et de faible épaisseur, inférieure ou égale à 80 nm, mieux inférieure ou égale à 50 nm et mieux encore inférieure ou égale à 30 nm.

Cette couche d'indice de réfraction élevé est directement en contact avec le substrat d'indice élevé ou le revêtement anti-abrasion d'indice de réfraction élevé.

En alternative, la sous-couche comprend, outre la couche de SiO₂ précitée et la couche d'indice de réfraction élevé précitée, une couche de matériau de bas indice de réfraction (c'est à dire inférieur ou égal à 1,54, de préférence inférieur ou égal à 1,52, mieux inférieur ou égal à 1,50) à base de SiO₂, exempte ou non d'Al₂O₃ sur laquelle est déposée la couche d'indice de réfraction élevé.

Typiquement, dans ce cas, la sous-couche comprend, déposées dans cet ordre à partir du substrat éventuellement revêtu d'un ou plusieurs revêtements fonctionnels, une couche de 25 nm de SiO₂, une couche de 10 nm de ZrO₂, une couche de 160 nm de SiO₂.

Dans la présente demande, une couche de l'empilement multicouches du revêtement anti-reflets (AR) est dite couche de haut indice de réfraction (HI) lorsque son indice de réfraction est supérieur ou égal à 1,6, de préférence supérieur ou égal à 1,7, mieux supérieur ou égal à 1,8 et encore mieux supérieur ou égal à 1,9. Une couche de l'empilement multicouches du revêtement anti-reflets est dite couche de bas indice de réfraction (BI) lorsque son indice de réfraction est inférieur ou égal à 1,54, de préférence inférieur ou égal à 1,52, mieux inférieur ou égal à 1,50.

Sauf indication contraire, les indices de réfraction auxquels il est fait référence dans la présente invention sont exprimés à 25 °C pour une longueur d'onde de 550 nm.

Les couches HI sont des couches d'indice de réfraction élevé classiques, bien connues dans la technique. Elles comprennent généralement un ou plusieurs oxydes minéraux tels que, sans limitation, la zircone (ZrO₂), l'oxyde de titane (TiO₂), le pentoxyde de tantale (Ta₂O₅), l'oxyde de néodyme (Nd₂O₅), l'oxyde de praséodyme (Pr₂O₃), le titanate de praséodyme (PrTiO₃), La₂O₃, Dy₂O₅, Nb₂O₅, Y₂O₃. Eventuellement, les couches haut indice peuvent contenir également de la silice ou de l'alumine, pourvu que leur indice de réfraction soit supérieur ou égal à 1,6, de préférence supérieur ou égal à 1,7, mieux supérieur ou égal à 1,8. Les matériaux préférés sont TiO₂, PrTiO₃, ZrO₂ et leurs mélanges.

Selon un mode de réalisation particulier de l'invention, au moins une couche HI de l'empilement multicouches est une couche à base de TiO₂, dont l'indice de réfraction élevé est particulièrement intéressant. Elle est de préférence déposée sous assistance ionique (IAD), ce qui augmente la compression de cette couche et par là son indice de réfraction.

Selon un autre mode de réalisation particulier de l'invention, au moins une couche HI de l'empilement multicouches est une couche à base de PrTiO₃, dont la résistance thermique élevée est particulièrement intéressante.

Les couches BI sont également bien connues et peuvent comprendre, sans limitation, SiO₂, MgF₂, ZrF₄, AlF₃, de la chiolite (Na₅Al₃F₁₄]), de la cryolite (Na₃[AlF₆]), et leurs mélanges, de préférence SiO₂ ou SiO₂ dopé avec de l'alumine, lequel contribue à augmenter la résistance thermique du revêtement anti-reflets. Bien évidemment, les mélanges de ces composés avec optionnellement un ou plusieurs autres matériaux choisis parmi les matériaux diélectriques décrits précédemment dans la présente description sont tels que l'indice de réfraction de la couche résultante est tel que défini ci-dessus (≤ 1,54).

Le dépôt des couches de bas indice de réfraction de l'empilement multicouches est de préférence réalisé dans une enceinte à vide sans apport de gaz dans l'enceinte à vide pendant ledit dépôt, en particulier sans apport d'oxygène, c'est-à-dire sans régulation de pression.

On obtient ainsi des couches BI plus denses que la couche à base de SiO₂ de la sous-couche lorsque celle-ci est déposée avec apport de gaz comme cela sera décrit ci-après.

Cet apport de gaz se distingue d'un traitement IAD qui sera décrit ultérieurement dans lequel la couche est bombardée par un faisceau d'espèces activées telles que des ions.

Lorsqu'une couche BI comprenant un mélange de SiO₂ et d'Al₂O₃ est utilisée, elle comprend préférentiellement de 1 à 10 %, mieux de 1 à 8 % et encore mieux de 1 à 5 % en masse d'Al₂O₃ par rapport à la masse totale de SiO₂ + Al₂O₃ dans cette couche. Une proportion trop importante d'alumine peut être défavorable à l'adhésion du revêtement AR.

Par exemple, SiO₂ dopé avec 4 % ou moins d'Al₂O₃ en masse, ou SiO₂ dopé avec 8 % d'Al₂O₃ peuvent être employés. Des mélanges SiO₂/Al₂O₃ disponibles dans le commerce peuvent être employés, tels que le LIMA® commercialisé par Umicore Materials AG (indice de réfraction n = 1,48-1,50 à 550 nm), ou la substance L5® commercialisée par Merck KGaA (indice de réfraction n = 1,48 à 500 nm).

Selon un mode de réalisation préférentiel, au moins une couche BI de l'empilement multicouches comprend un mélange de SiO₂ et d'Al₂O₃, de préférence consiste en un mélange de SiO₂ et d'Al₂O₃. Selon un autre mode de réalisation préférentiel, toutes les couches BI de l'empilement multicouches comprennent un mélange de SiO₂ et d'Al₂O₃, de préférence consistent en un mélange de SiO₂ et d'Al₂O₃. Dans ce dernier cas, il est particulièrement préférable que la sous-couche comprenne au moins une couche à base de SiO₂ exempte d'Al₂O₃ d'épaisseur de préférence supérieure ou égale à 75 nm.

Sans vouloir donner d'interprétation limitative à l'invention, les inventeurs pensent que la substitution dans la sous-couche de la silice pure par de la silice dopée par de l'alumine, dans le cas où plusieurs, voire toutes les couches BI de l'empilement multicouches comprennent un mélange de SiO₂ et d'Al₂O₃, augmente de façon trop importante la contrainte en compression de l'ensemble du revêtement anti-reflets, ce qui entraîne généralement des problèmes d'adhésion et une diminution de la résistance à l'abrasion.

Généralement, les couches HI ont une épaisseur physique variant de 10 à 120 nm, et les couches BI ont une épaisseur physique variant de 10 à 100 nm.

Préférentiellement, l'épaisseur physique totale du revêtement anti-reflets est inférieure à 1 micromètre, mieux inférieure ou égale à 500 nm et mieux encore inférieure ou égale à 250 nm. L'épaisseur physique totale du revêtement anti-reflets est généralement supérieure à 100 nm, de préférence supérieure à 150 nm. Les épaisseurs mentionnées dans la présente demande sont des épaisseurs physiques, sauf indication contraire.

De préférence encore, l'empilement multicouches comprend au moins deux couches de bas indice de réfraction (BI) et au moins deux couches de haut indice de réfraction (HI). Préférentiellement, le nombre total de couches de l'empilement multicouches est inférieur ou égal à 8, mieux inférieur ou égal à 6.

Il n'est pas nécessaire que les couches HI et BI soient alternées dans l'empilement, bien qu'elles puissent l'être selon un mode de réalisation de l'invention. Deux couches HI (ou plus) peuvent être déposées l'une sur l'autre, tout comme deux couches BI (ou plus) peuvent être déposées l'une sur l'autre. Ainsi, il peut être intéressant en termes de résistance à l'abrasion ou même optiquement d'empiler l'une sur l'autre par exemple une couche HI de ZrO₂ et une couche HI de TiO₂ plutôt que d'utiliser une couche de TiO₂ à la place de ces deux couches HI adjacentes.

De préférence, la sous-couche est adjacente à une couche de haut indice de réfraction (HI) de l'empilement multicouches.

Selon une autre préférence, la couche externe de l'empilement multicouches, c'est-à-dire sa couche la plus éloignée du substrat, est une couche comprenant un mélange d'oxyde silicium et d'oxyde d'aluminium.

Les différentes couches de l'empilement multicouches, dites "couches optiques", et la sous-couche sont préférentiellement déposées par dépôt sous vide selon l'une des techniques suivantes : i) par évaporation, éventuellement assistée par faisceau ionique ; ii) par pulvérisation par faisceau d'ion ; iii) par pulvérisation cathodique ; iv) par dépôt chimique en phase vapeur assisté par plasma. Ces différentes techniques sont décrites dans les ouvrages "Thin Film Processes" and "Thin Film Processes II," Vossen & Kern, Ed., Academic Press, 1978 et 1991 respectivement. Une technique particulièrement recommandée est la technique d'évaporation sous vide.

De préférence, toutes les couches du revêtement anti-reflets sont déposées par évaporation sous vide. Un tel procédé présente l'avantage d'éviter de chauffer le substrat, ce qui est particulièrement intéressant dans le cas des verres organiques.

Il est possible de réaliser une étape de traitement avec des espèces énergétiques telles que définies précédemment, notamment des ions, de façon concomitante au dépôt d'une ou plusieurs des différentes couches du revêtement anti-reflets, de préférence à l'exception de la couche à base de SiO₂ de la sous-couche. Les dépôts d'une ou plusieurs des couches de l'empilement multicouches et de la sous-couche peuvent notamment être réalisés sous assistance ionique (procédé "IAD" : Ion Assisted Déposition), la couche à base de SiO₂ de la sous-couche, qui peut être une couche de SiO₂, étant de préférence déposée sans assistance ionique. La technique de l'assistance ionique consiste à tasser lesdites couches avec des ions lourds, pendant qu'elles sont en train d'être formées, afin d'accroître leur densité. Outre une densification, elle permet d'améliorer l'adhérence des couches déposées et d'augmenter leur indice de réfraction.

Selon une caractéristique essentielle du procédé de l'invention, la surface à découvert de la sous-couche est soumise à un traitement de bombardement ionique avant le dépôt de l'empilement multicouches. Dans le cas d'une sous-couche multicouches, la surface soumise à un tel traitement est bien entendu celle qui sera en contact avec l'empilement multicouches de l'invention dans l'article d'optique final.

Ce traitement est généralement conduit sous vide, en utilisant par exemple un faisceau d'ions argon généré à l'aide d'un canon à ions. Les inventeurs ont constaté que, de façon surprenante, il permettait généralement d'une part d'améliorer les propriétés de résistance à l'abrasion du revêtement anti-reflets, et d'autre part d'augmenter ses propriétés d'adhésion, en particulier l'adhésion de l'empilement multicouches à la sous-couche.

Ces propriétés de résistance à l'abrasion peuvent être évaluées au moyen de tests BAYER, décrits dans la partie expérimentale. Les propriétés d'adhésion des couches du revêtement anti-reflets au substrat peuvent être évaluées au moyen du test communément appelé "nx10 coups", également décrit dans la partie expérimentale. Un test consistant en un traitement au trempé de l'article d'optique final dans l'eau chaude suivi d'une sollicitation mécanique de surface peut quant à lui être employé pour évaluer l'adhérence de la couche externe de l'empilement multicouches au reste du revêtement anti-reflets. La couche externe de l'empilement multicouches (c'est-à-dire du revêtement anti-reflets) est la couche de l'article d'optique qui est la plus à même de rencontrer des problèmes d'adhésion.

Il a cependant été constaté que dans certains cas, la présence de la sous-couche pouvait entraîner une diminution de l'adhésion de certaines couches du revêtement anti-reflets, malgré l'amélioration de ses propriétés de résistance à l'abrasion.

De façon surprenante, les inventeurs ont trouvé que ce problème d'adhésion pouvait être résolu en réalisant un apport de gaz pendant l'étape de dépôt de la sous-couche dans une enceinte à vide. Concrètement, un gaz tel qu'un gaz rare comme l'argon, le krypton, le xénon, le néon, des gaz tels que l'oxygène, l'azote, ou des mélanges de deux ou plus de ces gaz, est (sont) introduit(s) dans l'enceinte de dépôt sous vide pendant le dépôt de la sous-couche. De préférence, le gaz utilisé au cours de cette étape n'est pas un gaz activé, mieux n'est pas un gaz ionisé.

Cet apport de gaz permet de réguler la pression et est différent d'un traitement de bombardement ionique tel qu'une assistance ionique.

Le dépôt de la sous-couche ne met en jeu aucun traitement de bombardement ionique tel qu'une assistance ionique. De préférence, le dépôt de la sous-couche ne met en jeu aucun traitement par plasma dont les espèces ont une énergie supérieure ou égale à 30 eV, mieux ne met en jeu aucun traitement par plasma. De préférence encore, le dépôt de la sous-couche ne met en jeu aucun traitement par des ions ayant une énergie inférieure à 30 eV.

Typiquement, la pression pendant l'apport du ou des gaz peut varier de 5.10⁻⁵ à 2.10⁻⁴ mbar, de préférence de 8.10⁻⁵ à 2.10⁻⁴ mbar, mieux de 8.10⁻⁵ à 1,5.10⁻⁴ mbar.

Cette modification du procédé de dépôt (apport de gaz lors du dépôt de la sous-couche) permet de renforcer l'adhésion notamment à l'interface sous-couche/empilement multicouches et l'adhésion de la couche externe de l'empilement multicouches.

Sans vouloir être limités par une quelconque théorie, les inventeurs pensent que le dépôt de la sous-couche sans apport de gaz conduit à une couche plus dense, ce qui peut conduire à une mise sous contrainte (compression) trop forte du revêtement anti-reflets et donc à une diminution de ses propriétés d'adhésion. Le fait de réaliser le dépôt de la sous-couche sous régulation de pression de gaz, c'est-à-dire avec introduction concomitante de gaz dans l'enceinte de dépôt, permettrait de limiter l'augmentation de la contrainte en compression et d'éviter un affaiblissement de la structure du revêtement anti-reflets. On peut penser que cette façon de procéder conduirait à une sous-couche plus poreuse, développant moins de contraintes.

Les opérations d'IAD et de préparation de surface par traitement ionique du substrat et/ou de la sous-couche peuvent être effectuées au moyen d'un canon à ions (Commonwealth de type Mark II par exemple), les ions étant des particules constituées d'atomes de gaz dont on a extrait un ou plusieurs électron(s). Elles consistent préférentiellement en un bombardement de la surface à traiter par des ions argon (Ar⁺), d'une densité de courant comprise entre 10 et 100 µA/cm² sur la surface activée et sous une pression résiduelle dans l'enceinte à vide pouvant varier généralement de 8.10⁻⁵ mbar à 5.10⁻⁴ mbar, préférentiellement de 8.10⁻⁵ à 2.10⁻⁴ mbar.

Il est bien connu que les articles d'optique ont tendance à se charger en électricité statique, particulièrement lorsqu'ils sont nettoyés en conditions sèches par frottement de leur surface au moyen d'un chiffon, d'un morceau de mousse synthétique ou de polyester. Ils sont alors capables d'attirer et de fixer les petites particules se trouvant à proximité telles que les poussières, et ce durant tout le temps où la charge reste sur l'article. Il est bien connu dans l'état de la technique qu'un article peut acquérir des propriétés antistatiques grâce à la présence à sa surface d'une couche électriquement conductrice. Cette technique a été appliquée dans la demande internationale WO 01/55752 et le brevet EP 0834092.

Par "antistatique", on entend la propriété de ne pas retenir et/ou développer une charge électrostatique appréciable. Un article est généralement considéré comme ayant des propriétés antistatiques acceptables, lorsqu'il n'attire et ne fixe pas la poussière et les petites particules après que l'une de ses surfaces a été frottée au moyen d'un chiffon approprié.

Il existe différentes techniques pour quantifier les propriétés antistatiques d'un matériau.

Une de ces techniques consiste à prendre en compte le potentiel statique du matériau. Lorsque le potentiel statique du matériau (mesuré alors que l'article n'a pas été chargé) est de 0 KV +/- 0,1 KV (en valeur absolue), le matériau est antistatique, en revanche lorsque son potentiel statique est différent de 0 KV +/- 0,1 KV (en valeur absolue), le matériau est dit statique.

Selon une autre technique, la capacité d'un verre à évacuer une charge statique obtenue après frottement par un tissu ou par tout autre procédé de génération d'une charge électrostatique (charge appliquée par corona...) peut être quantifiée par une mesure du temps de dissipation de ladite charge. Ainsi, les verres antistatiques possèdent un temps de décharge de l'ordre de la centaine de millisecondes, alors qu'il est de l'ordre de plusieurs dizaines de secondes pour un verre statique.

L'article selon l'invention peut être rendu antistatique grâce à l'incorporation d'au moins une couche électriquement conductrice dans l'empilement multicouches. La couche électriquement conductrice peut être localisée à différents endroits du revêtement anti-reflets, pourvu que ses propriétés anti-réfléchissantes ne soient pas perturbées. Elle peut par exemple être déposée sur la sous-couche de l'invention et constituer la première couche de l'empilement multicouches. Elle est de préférence localisée sous une couche de bas indice de réfraction de l'empilement multicouches.

La couche électriquement conductrice doit être suffisamment fine pour ne pas altérer la transparence du revêtement anti-reflets. Généralement, son épaisseur varie de 0,1 à 150 nm, mieux de 0,1 à 50 nm, selon sa nature. Une épaisseur inférieure à 0,1 nm ne permet généralement pas d'obtenir une conductivité électrique suffisante, alors qu'une épaisseur supérieure à 150 nm ne permet généralement pas d'obtenir les caractéristiques de transparence et de faible absorption requises.

La couche électriquement conductrice est de préférence fabriquée à partir d'un matériau électriquement conducteur et hautement transparent. Dans ce cas, son épaisseur varie de préférence de 0,1 à 30 nm, mieux de 1 à 20 nm et encore mieux de 1 à 10 nm. La couche électriquement conductrice comprend de préférence un oxyde métallique choisi parmi les oxydes d'indium, d'étain, de zinc et leurs mélanges. L'oxyde d'étain-indium (In₂O₃:Sn, oxyde d'indium dopé à l'étain) et l'oxyde d'étain (In₂O₃) sont préférés. Selon un mode de réalisation optimal, la couche électriquement conductrice et optiquement transparente est une couche d'oxyde d'étain-indium, notée couche ITO.

Généralement, la couche électriquement conductrice contribue à l'obtention de propriétés anti-réfléchissantes et constitue une couche de haut indice de réfraction dans le revêtement anti-reflets. C'est le cas de couches fabriquées à partir d'un matériau électriquement conducteur et hautement transparent telles que les couches ITO.

La couche électriquement conductrice peut également être une couche d'un métal noble de très faible épaisseur, typiquement de moins de 1 nm d'épaisseur, mieux de moins de 0,5 nm.

De manière particulièrement avantageuse, l'empilement multicouches du revêtement anti-reflets comprend au moins quatre couches diélectriques, de préférence quatre ou cinq, et éventuellement une couche électriquement conductrice qui confère des propriétés antistatiques à l'article.

Selon un mode de réalisation préféré, sont déposées successivement, depuis la surface du substrat, une sous-couche de SiO₂ d'épaisseur de préférence supérieure ou égale à 75 nm, une couche de ZrO₂, généralement de 10 à 40 nm d'épaisseur et préférentiellement de 15 à 35 nm, une couche de SiO₂ ou de SiO₂/Al₂O₃, de préférence SiO₂/Al₂O₃, généralement de 10 à 40 nm d'épaisseur et préférentiellement de 15 à 35 nm, une couche de TiO₂, généralement de 40 à 150 nm d'épaisseur et préférentiellement de 50 à 120 nm, une couche de ZrO₂, généralement de 8 à 30 nm d'épaisseur et préférentiellement de 10 à 25 nm, éventuellement une couche électriquement conductrice, de préférence une couche ITO, généralement de 0,1 à 30 nm d'épaisseur et préférentiellement de 1 à 20 nm, et une couche de SiO₂ ou de SiO₂/Al₂O₃, de préférence SiO₂/Al₂O₃, généralement de 40 à 150 nm d'épaisseur et préférentiellement de 50 à 100 nm.

Il est préférable que l'empilement multicouches de l'invention comprenne une couche électriquement conductrice, et mieux, que l'article de l'invention comprenne un empilement TiO₂ / ZrO₂ / couche électriquement conductrice, la première couche citée étant la plus proche du substrat.

Selon un mode de réalisation particulièrement préféré, sont déposées successivement, depuis la surface du substrat, une sous-couche de SiO₂ d'épaisseur supérieure ou égale à 120 nm, une couche de ZrO₂ de 20 à 30 nm d'épaisseur, une couche de SiO₂/Al₂O₃ de 20 à 40 nm d'épaisseur, une couche de TiO₂ de 75 à 110 nm d'épaisseur, une couche de ZrO₂ de 8 à 20 nm d'épaisseur, une couche ITO de 2 à 20 nm d'épaisseur, et une couche de SiO₂/Al₂O₃ de 60 à 90 nm d'épaisseur.

La couche électriquement conductrice, qui est généralement une couche de haut indice de réfraction de l'empilement anti-reflets, peut être déposée selon toute technique appropriée, par exemple par dépôt sous vide par évaporation, de préférence assistée par faisceau ionique (IAD), ou bien par une technique de pulvérisation cathodique ou par faisceau d'ion.

Lorsqu'elles sont présentes, les trois couches successives TiO₂ / ZrO₂ / couche électriquement conductrice (de préférence ITO) sont de préférence toutes trois déposées sous assistance ionique (IAD).

La sous-couche et l'empilement multicouches peuvent être déposés directement sur un substrat nu. Dans certaines applications, il est préférable que la surface principale du substrat soit revêtue d'une couche de primaire anti-chocs, d'une couche anti-abrasion et/ou anti-rayures, ou d'une couche de primaire anti-chocs puis d'une couche anti-abrasion et/ou anti-rayures, dans cet ordre. D'autres revêtements classiquement utilisés en optique peuvent également être employés, par exemple un revêtement polarisé, un revêtement photochromique ou un revêtement coloré.

La sous-couche et l'empilement multicouches sont de préférence déposés sur un revêtement anti-abrasion et/ou anti-rayures. Le revêtement anti-abrasion et/ou anti-rayures peut être toute couche classiquement utilisée comme revêtement anti-abrasion et/ou anti-rayures dans le domaine des lentilles ophtalmiques.

Les revêtements résistant à l'abrasion et/ou aux rayures sont de préférence des revêtement durs à base de poly(méth)acrylates ou de silanes.

Les revêtements durs anti-abrasion et/ou anti-rayures sont de préférence élaborés à partir de compositions comprenant au moins un alcoxysilane et/ou un hydrolysat de celui-ci, obtenu par exemple par hydrolyse avec une solution d'acide chlorhydrique. Après l'étape d'hydrolyse, dont la durée est généralement comprise entre 2h et 24h, préférentiellement entre 2h et 6h, des catalyseurs peuvent optionnellement être ajoutés. Un composé tensioactif est de préférence également ajouté afin de favoriser la qualité optique du dépôt.

Parmi les revêtements recommandés dans la présente invention, on peut citer les revêtements à base d'hydrolysats d'époxysilanes tels que ceux décrits dans les brevets FR 2702486 (EP 0614957), US 4,211,823 et US 5,015,523.

Une composition pour revêtement anti-abrasion et/ou anti-rayures préférée est celle divulguée dans le brevet FR 2702486, au nom du déposant. Elle comprend un hydrolysat d'époxy trialcoxysilane et de dialkyl dialcoxysilane, de la silice colloïdale et une quantité catalytique de catalyseur de durcissement à base d'aluminium tel que l'acétylacétonate d'aluminium, le reste étant essentiellement constitué par des solvants classiquement utilisés pour la formulation de telles compositions. Préférentiellement l'hydrolysat utilisé est un hydrolysat de γ-glycidoxypropyltriméthoxysilane (GLYMO) et de diméthyldiéthoxysilane (DMDES).

La composition de revêtement anti-abrasion et/ou anti-rayures peut être déposée sur la surface principale du substrat par trempage ou centrifugation. Elle est ensuite durcie par la voie appropriée (de préférence thermique, ou UV).

L'épaisseur du revêtement anti-abrasion et/ou anti-rayures varie généralement de 2 à 10 µm, préférentiellement de 3 à 5 µm.

Préalablement au dépôt du revêtement anti-abrasion et/ou anti-rayures, il est possible de déposer sur le substrat un revêtement de primaire améliorant la résistance aux chocs et/ou l'adhésion des couches ultérieures dans le produit final.

Ce revêtement peut être toute couche de primaire anti-chocs classiquement utilisée pour les articles en matériau polymère transparent, tels que des lentilles ophtalmiques.

Parmi les compositions de primaire préférées, on peut citer les compositions à base de polyuréthanes thermoplastiques, telles que celles décrites dans les brevets japonais JP 63-141001 et JP 63-87223, les compositions de primaire poly(méth)acryliques, telles que celles décrites dans le brevet US 5,015,523, les compositions à base de polyuréthanes thermodurcissables, telles que celles décrites dans le brevet EP 0404111 et les compositions à base de latex poly(méth)acryliques ou de latex de type polyuréthane, telles que celles décrites dans les brevets US 5,316,791 et EP 0680492.

Les compositions de primaire préférées sont les compositions à base de polyuréthanes et les compositions à base de latex, en particulier les latex de polyuréthane.

Les latex poly(méth)acryliques sont des latex de copolymères constitués principalement par un (méth)acrylate, tel que par exemple le (méth)acrylate d'éthyle, de butyle, de méthoxyéthyle ou d'éthoxyéthyle, avec une proportion généralement mineure d'au moins un autre co-monomère, tel que par exemple du styrène.

Les latex poly(méth)acryliques préférés sont les latex de copolymères acrylate-styrène. De tels latex de copolymères acrylate-styrène sont disponibles commercialement auprès de la société ZENECA RESINS sous la dénomination NEOCRYL®.

Les latex de polyuréthane sont également connus et disponibles dans le commerce. A titre d'exemple, on peut citer les latex de polyuréthane contenant des motifs polyesters. De tels latex sont également commercialisés par la société ZENECA RESINS sous la dénomination NEOREZ® et par la société BAXENDEN CHEMICALS sous la dénomination WITCOBOND®.

On peut également utiliser dans les compositions de primaire des mélanges de ces latex, en particulier de latex polyuréthane et de latex poly(méth)acrylique.

Ces compositions de primaire peuvent être déposées sur les faces de l'article par trempage ou centrifugation puis séchées à une température d'au moins 70 °C et pouvant aller jusqu'à 100 °C, de préférence de l'ordre de 90 °C, pendant une durée de 2 minutes à 2 heures, généralement de l'ordre de 15 minutes, pour former des couches de primaire ayant des épaisseurs, après cuisson, de 0,2 à 2,5 µm, de préférence de 0,5 à 1,5 µm.

Bien évidemment, l'article d'optique selon l'invention peut également comporter des revêtements formés sur le revêtement anti-reflets et capables de modifier ses propriétés de surface, tels que des revêtements hydrophobes et/ou oléophobes (top coat anti-salissures). Ces revêtements sont de préférence déposés sur la couche externe du revêtement anti-reflets. Leur épaisseur est en général inférieure ou égale à 10 nm, de préférence de 1 à 10 nm, mieux de 1 à 5 nm.

Il s'agit généralement de revêtements de type fluorosilane ou fluorosilazane. Ils peuvent être obtenus par dépôt d'un fluorosilane ou fluorosilazane précurseur, comprenant de préférence au moins deux groupes hydrolysables par molécule. Les fluorosilanes précurseurs contiennent préférentiellement des groupements fluoropolyéthers et mieux des groupements perfluoropolyéthers. Ces fluorosilanes sont bien connus et sont décrits, entre autres, dans les brevets US 5,081,192, US 5,763,061, US 6,183, 872, US 5,739, 639, US 5,922,787, US 6,337,235, US 6,277,485 et EP 0933377.

Typiquement, un article d'optique obtenu par le procédé de l'invention comprend un substrat successivement revêtu d'une couche de primaire anti-chocs, d'une couche anti-abrasion et/ou anti-rayures, d'une sous-couche selon l'invention, d'un empilement multicouches selon l'invention et d'un revêtement hydrophobe et/ou oléophobe. L'article selon l'invention est de préférence une lentille optique, mieux une lentille ophtalmique pour lunettes, ou une ébauche de lentille optique ou ophtalmique. La lentille peut être une lentille polarisée ou une lentille photochromique ou une lentille colorée.

La coloration peut être obtenue par incorporation de pigments dans la masse de la lentille, par imprégnation, par dépôt de couches colorées, absorbant dans le visible.

En particulier, une ou plusieurs couches du revêtement anti-reflets obtenu par le procédé de l'invention peuvent être absorbantes, par exemple des couches à base d'oxyde de titane sous-stœchiométrique TiOₓ (x < 2) telle que décrites dans la demande de brevet WO 2005/059603, au nom du déposant.

De préférence, l'article d'optique obtenu par le procédé de l'invention n'absorbe pas dans le visible ou absorbe peu dans le visible, ce qui signifie, au sens de la présente demande, que son facteur de transmission dans le visible τ_{V}, encore nommé facteur relatif de transmission dans le visible, est supérieur à 90 %, mieux supérieur à 95 %, mieux encore supérieur à 96 % et de façon optimale supérieure à 97 %.

Le facteur τv répond à une définition internationale normalisée (norme ISO 13666:1998) et est mesuré conformément à la norme ISO 8980-3. Il est défini dans la gamme de longueur d'onde allant de 380 à 780 nm.

De préférence, l'absorption lumineuse de l'article revêtu selon l'invention est inférieure ou égale à 1 %.

De préférence encore, le facteur moyen de réflexion dans le domaine visible (400-700 nm) d'un article revêtu d'un revêtement anti-reflets selon l'invention, noté Rₘ, est inférieur à 2,5 % par face, mieux inférieur à 2 % par face et encore mieux inférieur à 1 % par face de l'article. Dans un mode de réalisation optimal, l'article comprend un substrat dont les deux surfaces principales sont revêtues d'un revêtement anti-reflets selon l'invention et présente une valeur de Rₘ totale (cumul de réflexion due aux deux faces) inférieure à 1%, de préférence comprise entre 0,7 et 0,8 %. Les moyens pour parvenir à de telles valeurs de Rₘ sont bien connus de l'homme du métier.

Dans la présente demande, le "facteur moyen de réflexion" est tel que défini dans la norme ISO 13666:1998, et mesuré conformément à la norme ISO 8980-4, c'est-à-dire qu'il s'agit de la moyenne de la réflexion spectrale sur l'ensemble du spectre visible entre 400 et 700 nm.

Les exemples suivants illustrent l'invention de façon plus détaillée mais non limitative.

### EXEMPLES

### 1. Procédures générales

Les articles d'optique employés dans les exemples comprennent un substrat de lentille ORMA® ESSILOR de 65 mm de diamètre, de puissance -2,00 dioptries et d'épaisseur 1,2 mm, revêtu sur ses deux faces du revêtement anti-abrasion et/ou anti-rayures (hard coat) divulgué dans l'exemple 3 du brevet EP 0614957 (d'indice de réfraction égal à 1,50), à base d'un hydrolysat de GLYMO et DMDES, de silice colloïdale et d'acétylacétonate d'aluminium, d'un revêtement anti-reflets et enfin d'un revêtement anti-salissures.

Le revêtement anti-abrasion a été obtenu par dépôt et durcissement d'une composition comprenant en masse, 224 parties de GLYMO, 80,5 parties de HCI 0,1 N, 120 parties de DMDES, 718 parties de silice colloïdale à 30 % massique dans le méthanol, 15 parties d'acétylacétonate d'aluminium et 44 parties d'éthylcellosolve. La composition comporte également 0,1 % de tensioactif FLUORAD™ FC-430® de 3M en masse par rapport à la masse totale de la composition. Ce revêtement anti-abrasion est déposé directement sur le substrat.

Les sous-couches et les couches de l'empilement multicouches du revêtement anti-reflets ont été déposées sans chauffage des substrats par évaporation sous vide, éventuellement assistée par faisceau ionique, lorsque précisé (source d'évaporation : canon à électrons), sur les deux faces des lentilles (concave et convexe).

Le mélange SiO₂/Al₂O₃ utilisé dans certains exemples est la substance L5® commercialisée par Merck KGaA. La silice SiO₂ évaporée provient de la société OPTRON et se présente sous la forme de granulés d'une taille de 1 à 2 mm.

Le revêtement anti-salissures a été obtenu par évaporation sous vide du composé Optool DSX® de la société Daikin Industries (épaisseur : 2-5 nm).

Pour tous les exemples à l'exception de l'exemple 6, le bâti de dépôt est une machine Leybold 1104 équipée d'un canon à électrons ESV14 (8kV) pour l'évaporation des oxydes, d'un creuset à effet Joule pour le dépôt du top coat et d'un canon à ions (Commonwealth Mark II) pour les phases préliminaires de préparation de la surface du substrat (IPC) et de la sous-couche par des ions argon, ainsi que pour les dépôts de couches sous assistance ionique (IAD). Pour l'exemple 6, le bâti de dépôt est une machine SATIS 1200DLF équipée d'un canon à ions Weeco Mark II.

L'épaisseur des couches est contrôlée au moyen d'une microbalance à quartz.

Les mesures de transmission de la lumière à travers les verres ont été effectuées en utilisant un spectrophotomètre de la société Zeiss une heure après la préparation des verres. Il a été vérifié que les valeurs de □v obtenues étaient stables en effectuant une deuxième mesure au bout d'une semaine.

### 2. Modes opératoires

### Exemples 1 à 6

Le procédé de préparation des articles d'optique comprend l'introduction du substrat revêtu d'un revêtement anti-abrasion dans une enceinte de dépôt sous vide, une étape de pompage jusqu'à l'obtention d'un vide secondaire, une étape d'activation de la surface du substrat par bombardement au moyen d'un faisceau d'ions argon (IPC) à une pression de 2.10⁻⁴ mBar (réglage canon à ions : 3,0 A - 150V), l'arrêt de l'irradiation ionique, l'évaporation successive du nombre requis de couches du revêtement anti-reflets, une étape de dépôt du revêtement anti-salissures (top coat) à une vitesse de 0,1 à 0,2 nm/s et enfin une étape de ventilation.

La formation du revêtement anti-reflets comprend une étape de dépôt de la sous-couche en SiO₂ avec une vitesse de 1 nm/s (sauf exemple 6: 1,2 nm/s), optionnellement (lorsque précisé) sous atmosphère de O₂ à une pression de 1.10⁻⁴ mBar (sauf exemple 6 : 1,3.10⁻⁴ mBar), une étape d'activation de la surface de la sous-couche durant 30 secondes au moyen d'un faisceau d'ions argon à une pression de 1.7.10⁻⁴ mBar (traitement identique à celui d'IPC déjà opéré directement sur le substrat), l'arrêt de l'irradiation ionique, le dépôt de la 1^{ère} couche HI (ZrO₂) avec une vitesse de 0,3 nm/s et optionnellement sous une pression d'O₂ de 6.10⁻⁵ mBar (uniquement pour l'exemple 6), le dépôt de la 1^{ère} couche BI (SiO₂ ou SiO₂/Al₂O₃) avec une vitesse de 0,7 nm/s, le dépôt de la 2^{nde} couche HI (ZrO₂ ou TiO₂) sous une pression de 1.10⁻⁴ mBar (sauf exemple 6 : pression d'O₂ de 6.10⁻⁵ mBar) avec une vitesse de 0,3 à 0,5 nm/s et une assistance d'ions oxygène correspondant à 3,5 A - 140 V (sauf exemple 6 : pas d'assistance ionique), le dépôt d'une 3^{ème} couche HI (ZrO₂) avec une vitesse de 0,3 nm/s (uniquement pour l'exemple 5), le dépôt d'une couche ITO avec une vitesse de 0,3 à 0,5 nm/s et une assistance d'ions oxygène correspondant à 3,5 A - 140 V (sauf exemple 6 : 2,0 A - 120 V), et enfin le dépôt de la 2^{nde} couche BI (SiO₂ ou SiO₂/Al₂O₃) avec une vitesse de 1 nm/s.

Aucune régulation de pression par introduction de gaz dans l'enceinte, en particulier d'oxygène, n'est effectuée lors du dépôt des couches BI.

### Exemples comparatifs C1 à C5

Les procédures utilisées dans les exemples comparatifs sont similaires. Les articles des exemples comparatifs 1 et 2 (exemples C1 et C2) ne comprennent pas de sous-couche. La sous-couche des articles des exemples comparatifs 3 à 5 (exemples C3 à C5) a été déposée sous atmosphère d'oxygène mais n'a pas subi de pré-nettoyage ionique avant le dépôt de l'empilement multicouches.

### 3. Caractérisations

### a. Caractérisation de la résistance à l'abrasion

La résistance à l'abrasion a été évaluée par détermination de valeurs BAYER sur les substrats revêtus d'une sous-couche (sauf exemples C1 et C2) et d'un empilement multicouches.

### Test BAYER sable

La détermination de cette valeur BAYER a été établie conformément à la norme ASTM F 735.81. Plus la valeur obtenue au test BAYER est élevée, plus la résistance à l'abrasion est élevée.

Ce test consiste à agiter simultanément un verre échantillon et un verre étalon d'un mouvement alternatif déterminé dans un bac contenant une poudre abrasive (sable) de granulométrie définie à une fréquence de 100 cycles/minute pendant 2 minutes. La mesure de diffusion H "avant / après" du verre échantillon est comparée à celle d'un verre étalon, en l'occurrence un verre nu à base de CR-39®, pour lequel la valeur BAYER est fixée à 1. La valeur Bayer sable est R = H étalon/H verre échantillon.

### Test Baver ISTM (Baver alumine)

La détermination de cette valeur BAYER a été établie en suivant la norme ASTM F735-81, avec les modifications suivantes :
L'abrasion s'effectue sur 300 cycles en utilisant approximativement 500 g d'alumine (oxyde d'aluminium Al₂O₃) ZF 152412 fournie par la société Ceramic Grains (anciennement Norton Materials, New Bond Street, PO Box 15137 Worcester, Mass. 01615-00137) à la place du sable. La diffusion est mesurée en utilisant un système Hazeguard modèle XL-211 produit par Pacific Scientific.

La valeur de Bayer ASTM (Bayer sable) est qualifiée de bonne lorsque R est supérieur ou égal à 3,4 et inférieur à 4,5. La valeur de Bayer ISTM est qualifiée de bonne lorsque R est supérieur ou égal à 3 et inférieur à 4,5. La valeur de Bayer Sable ou ISTM est qualifiée d'excellente pour des valeurs de 4,5 et plus.

### b. Caractérisation de l'adhésion de l'empilement anti-reflets sur le substrat (test nx10 coups)

Le test qualitatif connu sous le nom de test "nx10 coups" permet d'évaluer les propriétés d'adhésion d'un film déposé sur un substrat, notamment l'adhésion d'un revêtement anti-reflets à un substrat de lentille ophtalmique. Il a été réalisé sur la face convexe des lentilles en suivant la procédure décrite dans la demande internationale WO 99/49097 en utilisant un nombre de sollicitations égal à 50.

Une sollicitation (ou cycle) consiste en 10 fois un aller-retour de la gomme (eraser). L'opérateur a vérifié visuellement l'état de la lentille testée toutes les 3 sollicitations jusqu'à 12 sollicitations, puis toutes les 20, 30, 40 et 50 sollicitations. L'appréciation consiste à relever le nombre de sollicitations que peut supporter une lentille avant l'apparition d'un défaut. Par conséquent, plus la valeur obtenue au test n×10 coups est élevée, meilleure est l'adhésion du revêtement anti-reflets au substrat.

### 4. Résultats

La constitution des articles d'optique obtenus selon les exemples 1-6 et les exemples comparatifs 1-5 est détaillée dans le tableau 1 en pages 24 et 25 ci-après. Ce tableau comporte également les résultats des mesures d'adhésion, de transmission et de résistance à l'abrasion.

Les lentilles des exemples comparatifs 1 et 2 ne possèdent pas de sous-couche. Elles présentent une faible résistance à l'abrasion.

L'exemple comparatif C3, concerne un article présentant une sous-couche qui n'a pas subi un bombardement ionique avant le dépôt de l'empilement multicouches.

En ce qui concerne les articles des exemples comparatifs 4 et 5, qui comportent une sous-couche, les valeurs d'adhérence obtenues lors du test "n×10 coups" sont limitées.

La comparaison des valeurs Bayer obtenues pour les exemples C3 et 2, C4 et 4 ou C5 et 5 permet de constater l'effet positif d'un bombardement ionique de la surface de la sous-couche avant le dépôt de l'empilement multicouches du point de vue de la résistance à l'abrasion. Ce traitement permet généralement de renforcer la cohésion entre la sous-couche et l'empilement multicouches de l'invention.

Les lentilles des exemples 2, 4, 5 et 6, qui comportent une sous-couche de silice déposée avec régulation de pression d'O₂ et dont la surface de leur sous-couche a subi un bombardement ionique présentent d'excellentes valeurs de Bayer ISTM et de valeurs d'adhérence obtenues lors du test "n×10 coups."

Une comparaison des résultats des exemples 1 et 6 ou 2 et 3 confirme qu'un dépôt de la sous-couche effectué avec introduction d'un gaz dans l'enceinte pendant ledit dépôt améliore les propriétés mécaniques (adhésion et/ou résistance à l'abrasion) de l'empilement anti-reflets.

En outre, une comparaison des exemples 4 et 5 révèle que l'utilisation de deux couches HI TiO₂/ZrO₂ juxtaposées plutôt qu'une simple couche de TiO₂ améliore la résistance à l'abrasion.

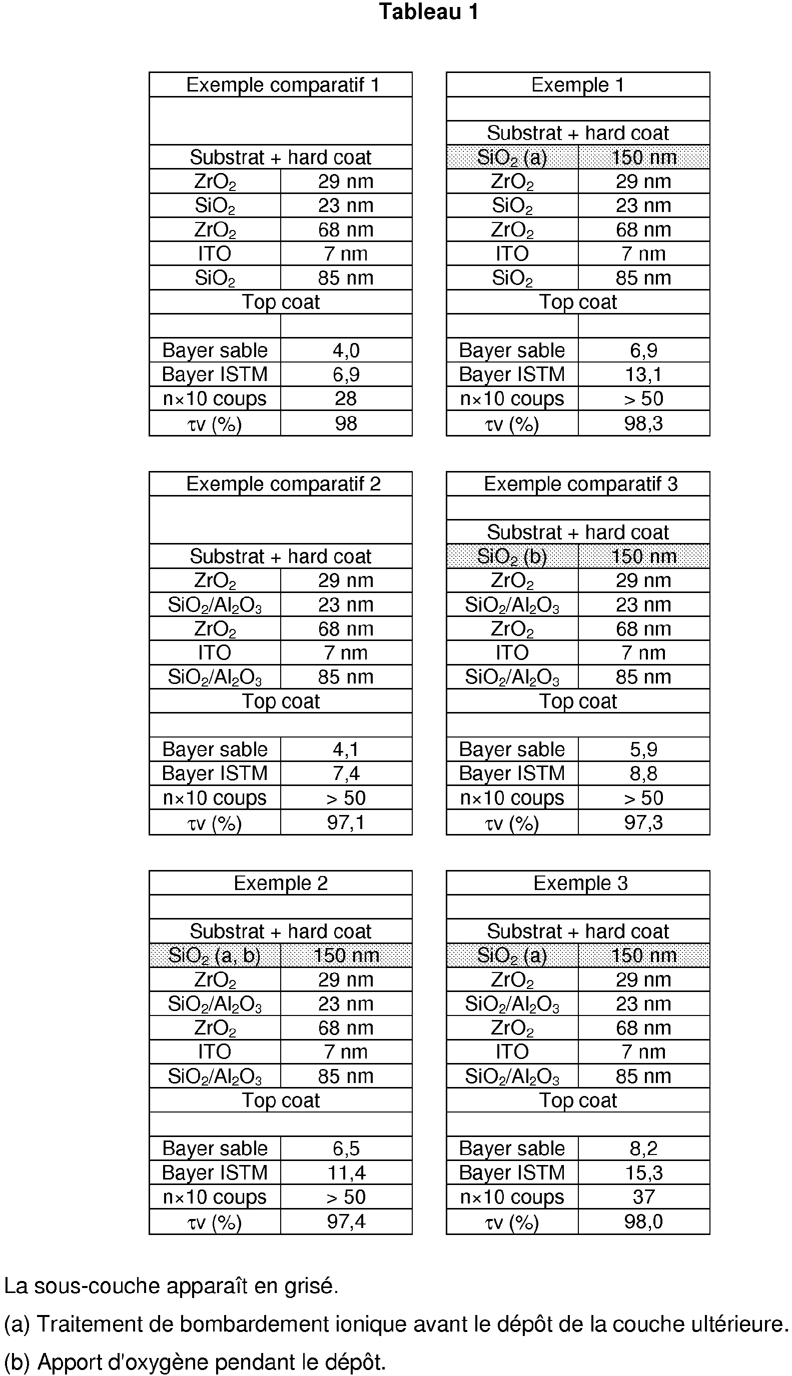

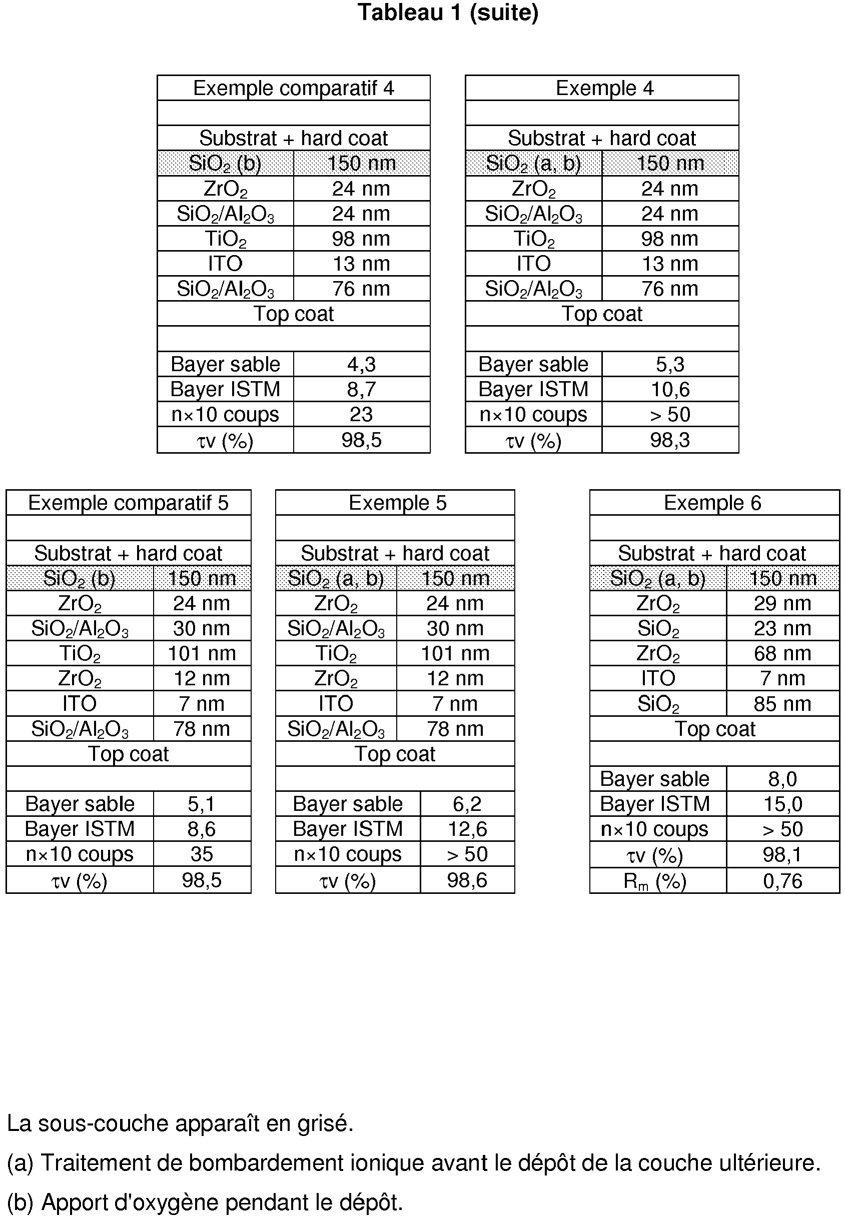

## Revendications

1. Procédé de fabrication d'un article d'optique à propriétés anti-reflets ou réfléchissantes, comprenant au moins les étapes suivantes :
- fournir un article d'optique comprenant un substrat ayant au moins une surface principale;
- déposer sur une surface principale du substrat une sous-couche ayant une surface exposée, ladite sous-couche comprenant une couche à base de SiO₂;
- déposer sur ladite surface exposée de la sous-couche un empilement anti-reflets ou réfléchissant multicouches comprenant au moins une couche de haut indice de réfraction et au moins une couche de bas indice de réfraction,
- récupérer un article d'optique comprenant un substrat ayant une surface principale revêtue d'un revêtement anti-reflets ou réfléchissant comprenant ladite sous-couche et ledit empilement multicouches,
**caractérisé en ce que** la surface exposée de la sous-couche est soumise à un traitement de bombardement ionique avant le dépôt dudit empilement multicouches, et **en ce que** le dépôt de ladite couche à base de SiO₂ est réalisé sans assistance ionique dans une enceinte à vide dans laquelle au moins un gaz supplémentaire permettant de réguler la pression est introduit pendant ledit dépôt.

2. Procédé selon la revendication 1, **caractérisé en ce que** l'article d'optique est un article à propriétés anti-reflets.

3. Procédé selon la revendication 1 ou 2, **caractérisé en ce que** le gaz est choisi parmi l'argon, le krypton, le xénon, le néon, l'oxygène, l'azote et leurs mélanges.

4. Procédé selon l'une quelconque des revendications 1 à 3, **caractérisé en ce que** ladite couche à base de SiO₂ de la sous-couche a une épaisseur supérieure ou égale à 75 nm, de préférence supérieure ou égale à 80 nm, mieux supérieure ou égale à 100 nm et encore mieux supérieure ou égale à 150 nm.

5. Procédé selon l'une quelconque des revendications précédentes, **caractérisé en ce que** la sous-couche consiste en ladite couche à base de SiO₂, de préférence consiste en une couche de SiO₂.

6. Procédé selon l'une quelconque des revendications précédentes, **caractérisé en ce que** ladite couche à base de SiO₂ est exempte d'Al₂O₃.

7. Procédé selon l'une quelconque des revendications 1 à 4, **caractérisé en ce que** ladite couche à base de SiO₂ est une couche de SiO₂ d'épaisseur supérieure ou égale 75 nm et exempte d'Al₂O₃ et **en ce que** la sous-couche comprend en outre au plus trois couches intercalées entre le substrat et cette couche de SiO₂ exempte d'Al₂O₃.

8. Procédé selon l'une quelconque des revendications précédentes, **caractérisé en ce que** la couche à base de SiO₂ est directement en contact avec l'empilement multicouches.

9. Procédé selon l'une quelconque des revendications précédentes, **caractérisé en ce que** le dépôt de la couche à base de SiO₂ est réalisé sans traitement concomitant avec des espèces énergétiques.

10. Procédé selon l'une quelconque des revendications précédentes, **caractérisé en ce que** le dépôt des couches de bas indice de réfraction de l'empilement multicouches est réalisé dans une enceinte à vide sans apport de gaz dans l'enceinte à vide pendant ledit dépôt.

11. Procédé selon l'une quelconque des revendications précédentes, **caractérisé en ce que** toutes les couches de bas indice de réfraction de l'empilement multicouches comprennent un mélange de SiO₂ et d'Al₂O₃, de préférence consistent en un mélange de SiO₂ et d'Al₂O₃.

12. Procédé selon l'une quelconque des revendications précédentes, **caractérisé en ce que** l'article d'optique est une lentille optique, de préférence une lentille ophtalmique.

13. Procédé selon l'une quelconque des revendications précédentes, **caractérisé en ce que** l'empilement multicouches est directement en contact avec la sous-couche.

14. Procédé selon l'une quelconque des revendications précédentes, **caractérisé en ce que** le dépôt de ladite couche à base de SiO₂ est réalisé sous une pression de 8.10⁻⁵ à 2x10⁻⁴ mbar.

15. Procédé selon l'une quelconque des revendications précédentes, **caractérisé en ce que** le dépôt de ladite couche à base de SiO₂ est réalisé sous une pression de 8.10⁻⁵ à 1.5x10⁻⁴ mbar.

16. Procédé selon l'une quelconque des revendications précédentes, **caractérisé en ce que** le dépôt de ladite couche à base de SiO₂ est réalisé sous une pression de 8.10⁻⁵ à 1.3x10⁻⁴ mbar.

17. Procédé selon l'une quelconque des revendications précédentes, **caractérisé en ce que** la sous-couche est déposée sur un revêtement anti-abrasion et/ou anti-rayures.

## Patentansprüche

1. Verfahren zur Herstellung eines optischen Artikels mit Antireflex- oder reflektierenden Eigenschaften, umfassend mindestens die folgenden Schritte:
- Bereitstellen eines optischen Artikels, umfassend ein Substrat, das mindestens eine Hauptfläche aufweist;
- Abscheiden, auf einer Hauptfläche des Substrats, einer Unterschicht, die eine freiliegende Fläche aufweist, wobei die Unterschicht eine Schicht auf der Basis von SiO₂ umfasst;
- Abscheiden, auf der freiliegenden Fläche der Unterschicht, eines mehrschichtigen Antireflex- oder reflektierenden Stapels, umfassend mindestens eine Schicht mit hohem Brechungsindex und mindestens eine Schicht mit niedrigem Brechungsindex;
- Erhalten eines optischen Artikels, umfassend ein Substrat, das eine Hauptfläche aufweist, die mit einer Antireflex- oder reflektierenden Beschichtung beschichtet ist, umfassend die Unterschicht und den mehrschichtigen Stapel;
**dadurch gekennzeichnet, dass** die freiliegende Fläche der Unterschicht einer Ionenbeschussbehandlung vor der Abscheidung des mehrschichtigen Stapels unterworfen wird, und dadurch, dass die Abscheidung der Schicht auf der Basis von SiO₂ ohne Ionenunterstützung in einer Vakuumhülle durchgeführt wird, in die mindestens ein ergänzendes Gas, das die Regelung des Drucks gestattet, während der Abscheidung eingebracht wird.

2. Verfahren nach Anspruch 1, **dadurch gekennzeichnet, dass** der optische Artikel ein Artikel mit Antireflex-Eigenschaften ist.

3. Verfahren nach Anspruch 1 oder 2, **dadurch gekennzeichnet, dass** das Gas aus Argon, Krypton, Xenon, Neon, Sauerstoff, Stickstoff und ihren Mischungen ausgewählt wird.

4. Verfahren nach einem der Ansprüche 1 bis 3, **dadurch gekennzeichnet, dass** die Schicht auf der Basis von SiO₂ der Unterschicht eine Dicke größer oder gleich 75 nm, vorzugsweise größer oder gleich 80 nm, besser größer oder gleich 100 nm und noch besser größer oder gleich 150 nm aufweist.

5. Verfahren nach einem der vorhergehenden Ansprüche, **dadurch gekennzeichnet, dass** die Unterschicht aus der Schicht auf der Basis von SiO₂ besteht, vorzugsweise aus einer Schicht aus SiO₂ besteht.

6. Verfahren nach einem der vorhergehenden Ansprüche, **dadurch gekennzeichnet, dass** die Unterschicht aus der Schicht auf der Basis von SiO₂ kein Al₂O₃ aufweist.

7. Verfahren nach einem der Ansprüche 1 bis 4, **dadurch gekennzeichnet, dass** die Schicht auf der Basis von SiO₂ eine Schicht aus SiO₂ mit einer Dicke größer oder gleich 75 nm und ohne Al₂O₃ ist, und dadurch, dass die Unterschicht außerdem höchstens drei Schichten umfasst, die zwischen dem Substrat und dieser Schicht aus SiO₂ und ohne Al₂O₃ angeordnet sind.

8. Verfahren nach einem der vorhergehenden Ansprüche, **dadurch gekennzeichnet, dass** die Schicht auf der Basis von SiO₂ direkt mit dem mehrschichtigen Stapel in Kontakt steht.

9. Verfahren nach einem der vorhergehenden Ansprüche, **dadurch gekennzeichnet, dass** die Abscheidung der Schicht auf der Basis von SiO₂ ohne gleichzeitige Behandlung mit Energiearten durchgeführt wird.

10. Verfahren nach einem der vorhergehenden Ansprüche, **dadurch gekennzeichnet, dass** die Abscheidung der Schichten mit niedrigem Brechungsindex des mehrschichtigen Stapels in einer Vakuumhülle ohne Einbringen von Gas in die Vakuumhülle während der Abscheidung durchgeführt wird.

11. Verfahren nach einem der vorhergehenden Ansprüche, **dadurch gekennzeichnet, dass** alle Schichten mit niedrigem Brechungsindex des mehrschichtigen Stapels eine Mischung von SiO₂ und Al₂O₃ umfassen, vorzugsweise aus einer Mischung von SiO₂ und Al₂O₃ bestehen.

12. Verfahren nach einem der vorhergehenden Ansprüche, **dadurch gekennzeichnet, dass** der optische Artikel eine optische Linse, vorzugsweise eine ophthalmische Linse ist.

13. Verfahren nach einem der vorhergehenden Ansprüche, **dadurch gekennzeichnet, dass** der mehrschichtige Stapel direkt mit der Unterschicht in Kontakt steht.

14. Verfahren nach einem der vorhergehenden Ansprüche, **dadurch gekennzeichnet, dass** die Abscheidung der Schicht auf der Basis von SiO₂ unter einem Druck von 8.10⁻⁵ bis 2 x 10⁻⁴ mbar durchgeführt wird.

15. Verfahren nach einem der vorhergehenden Ansprüche, **dadurch gekennzeichnet, dass** die Abscheidung der Schicht auf der Basis von SiO₂ unter einem Druck von 8.10⁻⁵ bis 1,5 x 10⁻⁴ mbar durchgeführt wird.

16. Verfahren nach einem der vorhergehenden Ansprüche, **dadurch gekennzeichnet, dass** die Abscheidung der Schicht auf der Basis von SiO₂ unter einem Druck von 8.10⁻⁵ bis 1,3 x 10⁻⁴ mbar durchgeführt wird.

17. Verfahren nach einem der vorhergehenden Ansprüche, **dadurch gekennzeichnet, dass** die Unterschicht auf einer abrasionsbeständigen und/oder kratzbeständigen Beschichtung abgeschieden wird.

## Claims

1. A method for producing an optical article having antireflection or reflective properties, comprising at least the steps of:
- providing an optical article comprising a substrate having at least one main surface;
- depositing onto a main surface of the substrate a sub-layer having an exposed surface, said sub-layer comprising a SiO₂ based layer;
- depositing onto said exposed surface of the sub-layer a multilayered antireflection or reflective stack comprising at least one high refractive index layer and at least one low refractive index layer,
- recovering an optical article comprising a substrate having a main surface coated with an antireflection or a reflective coating comprising said sub-layer and said multilayered stack,
wherein the exposed surface of the sub-layer has been submitted to an ionic bombardment treatment prior to depositing said multilayered stack, and wherein the deposition of said SiO₂ based layer is conducted without ion assistance in a vacuum chamber in which at least one supplementary gas allowing to regulate the pressure is supplied during said deposition.

2. A method according to claim 1, wherein the optical article is an article having antireflection properties.

3. A method according to claim 1 or 2, wherein the gas is selected from argon, krypton, xenon, neon, oxygen, nitrogen and mixtures thereof.

4. A method according to any one of claims 1 to 3, wherein said SiO₂ based layer of the sub-layer has a thickness greater than or equal to 75 nm, preferably greater than or equal to 80 nm, more preferably greater than or equal to 100 nm and even more preferably greater than or equal to 150 nm.

5. A method according to any one of the preceding claims, wherein the sub-layer consists of said SiO₂ based layer, preferably consists of a SiO₂ layer.

6. A method according to any one of the preceding claims, wherein said SiO₂ based layer is free from Al₂O₃.

7. A method according to any one of claims 1 to 4, wherein said SiO₂ based layer is a SiO₂ layer with a thickness greater than or equal to 75 nm and free from Al₂O₃ and wherein the sub-layer further comprises at most three layers inserted between the substrate and this SiO₂ layer that is free from Al₂O₃.

8. A method according to any one of the preceding claims, wherein the SiO₂ based layer does directly contact the multilayered stack.

9. A method according to any one of the preceding claims, wherein the deposition of the SiO₂ based layer is conducted without concomitant treatment with energetic species.

10. A method according to any one of preceding claims, wherein the deposition of the low refractive index layers of the multilayered stack is conducted in a vacuum chamber with no gas supply to the vacuum chamber during said deposition coating.

11. A method according to any one of preceding claims, wherein all the low refractive index layers of the multilayered stack comprise a mixture of SiO₂ and Al₂O₃, preferably consist of a mixture of SiO₂ and Al₂O₃.

12. A method according to any of preceding claims, wherein the optical article is an optical lens, preferably an ophthalmic lens.

13. A method according to any of preceding claims, wherein the multilayered stack does directly contact the sub-layer.

14. A method according to any of preceding claims, wherein the deposition of said SiO₂ based layer is carried out under a pressure of 8.10⁻⁵ to 2x10⁻⁴ mbar.

15. A method according to any of preceding claims, wherein the deposition of said SiO₂ based layer is carried out under a pressure of 8.10⁻⁵ to 1.5x10⁻⁴ mbar.

16. A method according to any of preceding claims, wherein the deposition of said SiO₂ based layer is carried out under a pressure of 8.10⁻⁵ to 1.3x10⁻⁴ mbar.

17. A method according to any of preceding claims, wherein the sub-layer is deposited onto an abrasion-resistant and/or an anti-scratch coating.
